# EUROPEAN PATENT SPECIFICATION

(11) **EP 2 340 297 B1**
(45) Date of publication and mention of the grant of the patent: **08.04.2015**
(21) Application number: 09819702.3
(22) Date of filing: 05.10.2009
(51) Int. Cl.: C10M 169/04, C10M 101/02, C10M 143/10, C10M 125/24, C10N 30/10, C10N 40/16, C08K 5/5313

(54) **COMPOSITION, METHOD OF MAKING THE SAME, AND USE THEREOF**
ZUSAMMENSETZUNG, VERFAHREN ZU IHRER HERSTELLUNG UND IHRE VERWENDUNG
COMPOSITION, SON PROCÉDÉ DE FABRICATION ET SON UTILISATION

(30) Priority: 07.10.2008 US 103288 P
(43) Date of publication of application: 06.07.2011
(73) Proprietor: 3M Innovative Properties Company, Saint Paul, MN 55133-3427 (US)
(72) Inventor: PYUN, Eumi, Saint Paul, Minnesota 55133-3427 (US); LIM, Lisa, S., Sandy, Utah 84094 (US); LIN,Haohao, Saint Paul, Minnesota 55133-3427 (US); DOWER, William, V., Saint Paul, Minnesota 55133-3427 (US); BERGLUND, Sidney, J., Saint Paul, Minnesota 55133-3427 (US)
(74) Representative: Vossius & Partner
(86) International application number: PCT/US2009/059493
(87) International publication number: WO 2010/042422

(56) References cited:
- EP-A1- 1 988 106
- EP-A1- 1 995 280
- EP-A2- 1 944 335
- WO-A1-94/08710
- WO-A1-2007/108202
- US-A- 5 358 664
- US-A- 5 741 843
- US-A1- 2003 193 116
- US-A1- 2008 171 800

## Description

### TECHNICAL FIELD

The present disclosure broadly relates to compositions including oil, an elastomer and a flame retardant. The present disclosure also relates to methods of making the compositions, and uses of the compositions.

### BACKGROUND

Insulation-displacement connector gel (IDC gel) is used in some electrical connectors (for example, electrical connectors used in the telecommunications industry) to provide electrical insulation and moisture resistance. This type of protection is particularly useful in subterranean installations. Among such gels, oil-based systems are common. Types of oil-based gels include silicone oil based gels and hydrocarbon oil-based gels. The gels typically include a network (for example, a polymer network) swelled with an oil phase. Polymer networks may be covalently (for example, in the case of thermoset polymer networks) or physically bonded (for example, in the case of styrene-rubber-styrene triblock elastomers).

### SUMMARY

In one aspect, the present disclosure provides, a composition comprising in relative proportion: 60 to 94 parts by weight of mineral oil; 1 to 30 parts by weight of at least one thermoplastic elastomer; and 5 to 30 parts by weight of non-halogenated metal phosphinate, wherein the non-halogenated metal phosphinate has a decomposition temperature of at least 240 degrees Celsius (that is, °C), and wherein the composition is a gel.

In some embodiments, the composition further comprises 0.01 to 2 parts by weight of an antioxidant. In some embodiments, the at least one thermoplastic elastomer comprises a styrenic block copolymer. In some embodiments, the at least one thermoplastic elastomer is selected from the group consisting of styrene-ethylene/butylene-styrene block copolymers, styrene-ethylene/propylene-styrene block copolymers, and combinations thereof.

In some embodiments, the at least one thermoplastic elastomer comprises at least one of a diblock copolymer or a triblock copolymer. In some of those embodiments, the at least one thermoplastic elastomer comprises at least one diblock copolymer and at least one triblock copolymer in a respective weight ratio of from 0.25 to 4.

In some embodiments, the at least one thermoplastic elastomer has an average molecular weight in a range of from 150,000 to 450,000 grams per mole; for example, the at least one thermoplastic elastomer may have an average molecular weight in a range of from 200,000 to 300,000 grams per mole. In some embodiments, the composition comprises 80 to 90 parts by weight of the mineral oil. In some embodiments, the composition comprises 4 to 8 parts by weight of the at least one thermoplastic elastomer. In some embodiments, the composition comprises 10 to 15 percent of the non-halogenated metal phosphinate. In some embodiments, the non-halogenated metal phosphinate is represented by the formula 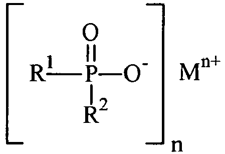 wherein each of R¹ and R² independently represents a hydrocarbyl group, M represents a metal, and n represents and integer of from 1 to 4. In some embodiments, the non-halogenated metal phosphinate comprises aluminum diethylphosphinate.

Compositions according to the present disclosure are useful; for example, as an encapsulant (for example, a re-enterable encapsulant) for electrical connections and/or electrical circuits.

In another aspect, the present disclosure provides a method of making a composition, the method comprising combining components comprising: 60 to 94 parts by weight of mineral oil, 1 to 30 parts by weight of thermoplastic elastomer, and 5 to 30 parts by weight of a non-halogenated metal phosphinate to provide a gel.

In some embodiments, the components are combined with heating at a temperature of at least 200 °C. In some embodiments, the at least one thermoplastic elastomer is selected from the group consisting of styrene-ethylene/butylene-styrene block copolymers, styrene-ethylene/propylene-styrene block copolymers, and combinations thereof.

Advantageously, compositions according to the present disclosure are typically useful as encapsulants in electrical connectors, and are capable of providing a degree of flame retardancy using relatively cheap mineral oil and thereby avoiding the need to use expensive alternatives such as, for example, silicone oils.

All numerical ranges in this application, including the specification and claims, are inclusive of their endpoints unless otherwise indicated.

In this application:
"block copolymer" means a polymer containing discrete blocks of homopolymeric segments separated by one or more homopolymeric and/or copolymeric segments;
"elastomer" means an elastic polymer;
"gel" means a semisolid viscoelastic material that can resist some mechanical stress without permanent deformation;
"hydrocarbyl group" refers to a univalent group formed by removing a hydrogen atom from a hydrocarbon;
"non-halogenated" means free of halogen atoms; and
"thermoplastic" means capable of softening or fusing when heated and of hardening again when cooled.

### DETAILED DESCRIPTION

Compositions according to the present disclosure are gels. They comprise in relative proportion: 60 to 94 parts by weight of mineral oil; 1 to 30 parts by weight of thermoplastic elastomer; and 5 to 30 parts by weight of non-halogenated metal phosphinate having a decomposition temperature of at least 240 °C. That is, for every 60 to 94 parts by weight of mineral oil the composition contains 1 to 30 parts by weight of thermoplastic elastomer; and 5 to 30 parts by weight of a non-halogenated metal phosphinate having a decomposition temperature of at least 240 °C.

The term mineral oil is used herein according to its ordinary usage, and refers to any of various light hydrocarbon oils, especially distillates of petroleum. Typically, the mineral oil is a white mineral oil although other mineral oils may be used. White mineral oils are generally colorless, odorless, tasteless mixtures of saturated paraffinic and naphthenic hydrocarbons that span a viscosity range of 50-370 Saybolt Universal Seconds (228 to 1680 centistokes) at 100 °F (38 °C). Nearly chemically inert, white mineral oils are essentially free of nitrogen, sulfur, oxygen and aromatic hydrocarbons. Mineral oil (60 to 94 parts by weight) is used in combination with 1 to 30 parts by weight of thermoplastic elastomer and 5 to 30 parts by weight of a non-halogenated metal phosphinate. Typically, 70 to 94 parts by weight of mineral oil, or even more typically 80 to 90 parts by weight of mineral oil are used in combination with 1 to 30 parts by weight of the at least one thermoplastic elastomer and 5 to 30 parts by weight of the non-halogenated metal phosphinate.

Thermoplastic elastomers, sometimes referred to as thermoplastic rubbers, are a class of copolymers or a physical mix of polymers (usually a plastic and a rubber) which consist of materials with both thermoplastic and elastomeric properties. Thermoplastic elastomers show both advantages typical of rubbery materials and plastic materials. Crosslinking between polymer chains in thermoplastic elastomers is typically due to a relatively weak dipole or hydrogen bond, or takes place in only in one of the phases of the material (for example, crystallization).

There are at least six generic classes of thermoplastic elastomers available commercially. They include for example styrenic block copolymers, polyolefin blends, elastomeric alloys, thermoplastic polyurethanes, thermoplastic copolyester and thermoplastic polyamides. Examples of thermoplastic elastomers include: block copolymers such as those available under the trade designations STYROFLEX (from BASF Corp. of Parsippany, New Jersey), KRATON (from Kraton Polymers, Inc. of Houston, Texas), SEPTON (from Kuraray Co., Ltd. of Tokyo, Japan), PELLETHANE (from Dow Chemical of Midland, Michigan), PEBAX and ARNITEL (available from DSM of The Netherlands), HYTREL (from E. I. du Pont de Nemours and Co. of Wilmington, Delaware); and elastomer alloys such as those available under the trade designations SANTOPRENE and GEOLAST (from Monsanto Co. of Saint Louis, Missouri) and ALCRYN (from E. I. du Pont de Nemours and Co.); and mixtures and blends thereof. Typically, the at least one thermoplastic elastomer comprises at least one block copolymer comprising one or more (for example, at least two) polystyrene block(s) adjacent a non-crystalline polymeric segment. Examples include diblock polymers such as styrene-ethylene/propylene (SEP) block copolymers and styrene-butadiene (SB) block copolymers; triblock copolymers such as styrene-isoprene-styrene (SIS) block copolymers, styrene-butadiene-styrene (SBS) block copolymers, styrene-ethylene/butylene-styrene (SEBS) block copolymers, and styrene-ethylene/propylene-styrene (SEPS) block copolymers; tetrablock copolymers such as styrene-(ethylene-butylene)-styrene-(ethylene-butylene) (SEBSEB) block copolymers and styrene-ethylene-ethylene/propylene-styrene (SEEPS) block copolymers; and combinations of one or more of the foregoing. Examples of suitable thermoplastic elastomers include those marketed under the trade designation KRATON G series (for example, KRATON G1650, G1650, G1652, G1654H, G1701 (including G1701E), and G1702, from Kraton Polymers, Inc.), and those marketed by Kuraray America, Inc. of Houston, Texas under the trade designation SEPTON (SEPTON 4077).

If diblock copolymers are combined with triblock copolymers, they may be combined in a respective weight ratio of from 0.25 to 4; for example, in a respective weight ratio of from 0.25 to 0.5.

The amount of thermoplastic elastomer(s) included in the composition is in an amount of 1 to 30 parts by weight (typically 2 to 15 parts by weight, and even more typically 4 to 8 parts by weight) of thermoplastic elastomer(s) for every 60 to 94 parts by weight of mineral oil and 5 to 30 parts by weight of the non-halogenated metal phosphinate having a decomposition temperature of at least 240 °C. The specific choice of thermoplastic elastomer should take into account its degree of compatibility (for example, swellability) with mineral oil and how well it will facilitate gel formation.

The non-halogenated metal phosphinate is present in an amount of 5 to 30 parts by weight (for example, 8 to 20 parts by weight or 10 to 15 parts by weight) for every 60 to 94 parts by weight of mineral oil and 1 to 30 parts by weight of thermoplastic elastomer. In addition to being non-halogenated, the non-halogenated metal phosphinate is relatively thermally stable (for example, it has a decomposition temperature of at least 240 °C) which permits its use in melt compounding, in some embodiments, which may involve processing temperatures of up to 260 °C, or more. The non-halogenated metal phosphinate may comprise a single compound or a mixture of non-halogenated metal phosphinates. In some embodiments, the non-halogenated metal phosphinate has a decomposition temperature of at least 260, 280, 300, 320, 340, 360, 380, or even 400 °C. Advantageously, the high decomposition temperature of the non-halogenated metal phosphinate enables high temperature compounding during preparation of compositions according to the present disclosure.

In some embodiments, the non-halogenated metal phosphinate is represented by the formula 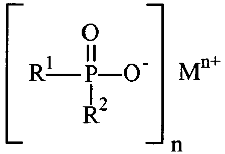 wherein each of R¹ and R² independently represents a hydrocarbyl group (for example, an alkyl group (linear or branched and/or cyclic), an aryl group, an alkaryl group, an aralkyl group), M represents a metal (for example, an alkali metal, alkaline earth metal, transition metal, or element from group 14 of the periodic table), and n represents and integer of from 1 to 4. Typically, R¹ and R² have from 1 to 12 carbon atoms, more typically, 1 to 6 carbon atoms. Exemplary alkyl groups represented by R¹ and R² include methyl, ethyl, n-propyl, isopropyl, n-butyl, t-butyl, n-pentyl, and n-hexyl, n-octyl, and n-dodecyl.

Examples of M in the aforementioned general formula (1) include alkali metals such as lithium, sodium, and potassium; alkaline earth metals such as magnesium, calcium, strontium, and barium; transition metals such as iron, cobalt, nickel, titanium, and zinc; and typical elements of group 14 of the periodic table such as, for example, aluminum.

One exemplary non-halogenated metal phosphinate is available as EXOLIT OP930 from Clariant Corp. of Charlotte, North Carolina, which is reported in paragraph [0120] of U. S. Pat. Appl. Publ.2006/0234045 A1 (Nakanishi et al.) to be aluminum diethylphosphinate, phosphorus content = 23 percent by mass. This compound typically has good heat stability and forms stable dispersions in compositions according to the present invention.

Typically, compositions according to the present disclosure comprise one or more antioxidants, but this is not a requirement. If present, the antioxidant is typically included in an amount of 1 percent or less, although more may be used. Exemplary antioxidants include: 2,6-di-t-butyl-p-cresol (BHT); benzenepropanoic acid, 3,5-bis(1,1-dimethylethyl)-4-hydroxy-, 2,2-bis((3-(3,5-bis(1,1-dimethylethyl)-4-hydroxyphenyl)-1-oxopropoxy)methyl)-1,3-propanediyl ester available as IRGANOX 1010 from Ciba Specialty Chemicals Corp. of Tarrytown, New York; benzenepropanoic acid, 3,5-bis(1,1-dimethylethyl)-4-hydroxy-, octadecyl ester available as IRGANOX 1076 from Ciba Specialty Chemicals Corp.; 4,6-bis(octylthiomethyl)-o-cresol, available as IRGANOX 1520 from Ciba Specialty Chemicals Corp.; octadecyl 3-(3,5-di-t-butyl-4-hydroxyphenyl) propionate; triethylene glycol-bis-3-(3-t-butyl-4-hydroxy-5-methyl phenyl) propionate; and 1,1,3-tris(5-t-butyl-4-hydroxy-5 methyl phenyl) butane.

One or more optional additives may also be included in the composition. Examples include fillers, plasticizers, fragrances, antioxidants, and colorants.

Compositions according to the present disclosure can be made by any suitable method. In one exemplary method, the components of the composition are combined with mixing and heating to sufficient temperature to soften the thermoplastic elastomer(s). This temperature may be as high as 200 °C, 220 °C, 240 °C, or more in some cases. After mixing is complete the composition is cooled resulting in a gel. Typically, the non-halogenated metal phosphinate is well dispersed throughout the composition, and remains dispersed for an extended period of time (for example, for days, weeks, years), although these are not requirements.

Compositions according to the present disclosure are useful; for example, as encapsulants (for example, IDC gel), sealing gels, and/or potting materials included in electrical connectors (for example, telecommunications connectors), splice closures, and electrical circuits (for example, on a printed circuit board such as a personal computer mother board). For example, the compositions may be used in conjunction with a connector available as 3M MS² SEALANT BOX 4075-S from 3M Company, of Saint Paul, Minnesota.

For the purposes of the present disclosure, a sealing gel is a material which has a surface that can conform to provide a seal which blocks the entry of water or other environmental contamination. Sealing gels can be represented by two broad classes: soft rubbers and greases. Soft rubbers are elastic solids which embody memory and which return to shape after distortions which do not exceed their elastic limit. The softer material can have elongation to failure of over 100 percent and in some cases over 500 percent. Their adhesion to a surface is exceeded by their cohesive strength, so that if the material is touched by a finger with sufficient pressure to distort its shape and then the finger is removed from contact with the material, the material returns substantially to its original shape and the finger has essentially no transferred material on it. In contrast, a grease is a viscoelastic fluid with a yield point. When sheared beyond this yield point, it will flow and not retain a 'memory' of its original shape. In the case of a grease, adhesion exceeds its cohesion. Hence, touching a grease surface with a finger permanently distorts the shape of the grease, and, upon removing the finger from contact with the grease, the finger will retain a portion of the grease.

Objects and advantages of this disclosure are further illustrated by the following nonlimiting examples, but the particular materials and amounts thereof recited in these examples, as well as other conditions and, details, should not be construed to unduly limit this disclosure.

### EXAMPLES

Unless otherwise noted, all parts, percentages, ratios, etc. in the Examples and the rest of the specification are by weight.

### Base Composition A

A base composition was made by extruding 89 parts KAYDOL white mineral oil (from Sonneborn Refined Products B.V., Haarlem , The Netherlands), 11.1 parts of KRATON G4609H (an SEBS block copolymer/oil blend containing 43 to 52 percent by weight percent of white mineral oil, 2 to 6 percent by weight of calcium carbonate, 0.02 top 0.06 percent by weight of antioxidant, with the remainder being a linear triblock copolymer based on styrene and ethylene/butylene and having a polystyrene content of 33 percent, from Kraton Polymers, Inc.), and 0.2 parts IRGANOX 1010 phenolic antioxidant (obtained from Ciba Specialty Chemicals, Tarrytown, New York) using a Werner and Pfleiderer Model: ZSK 30 (from Krupp Werner and Pfleiderer GmbH, Stuttgart, Germany) twin-screw extruder operating at 400 rpm. The temperature profile was set as follows: zones 1 = 204 °C, zones 2-7 = 249 °C.

### Conductivity / Humidity Aging Test

DC electrical conductivity of each specimen was measured in a parallel plate configuration with the High Temperature Broadband Dielectric Spectrometer (0.01-10,000,000 MHz) obtained from Novocontrol Technologies GmbH & Co. KG of Hundsangen, Germany. The DC conductivity was obtained from the low frequency extrapolation by fitting the imaginary permittivity data (dielectric loss) vs. frequency to a single dielectric relaxation process acting simultaneously with the DC conduction mechanism. The maximum resolution of this electrical conductivity measurement technique is believed to be approximately 10⁻¹⁷ S/cm.

Gel specimens were aged at 93 percent relative humidity and 23 °C for one month. DC electrical conductivity of test specimens was measured three times: before the aging, after 1 week of aging, and after 1 month of aging. If in all three times, the specimens had a conductivity of less than 10⁻¹⁴ S/cm, they received a "pass" rating. Otherwise, they were rated as "fail".

### Mixing with Gel Test

Five grams of flame retardant to be evaluated were added to 45 g of a Base Composition A gel specimen to be evaluated which had been melted at 200 °C, and then mixed for one minute using a SPEEDMIXER DAC 150FVZ available from FlackTek, Inc. of Landrum, South Carolina operating at 3000 rpm. The appearance of the mixed sample was visually inspected after it was cooled down for uniform mixing. If uniform mixing was not observed, then the sample was rated a "fail". The mixed sample was heated at 200 °C for 30 minutes to see whether the flame retardant would settle out from the gel. If settling was observed, then the sample was rated a "fail". A specimen that failed either or both evaluation(s) (above) was rated as "fail". If a specimen failed neither evaluation (above) then it was rated as "pass".

Physical properties of various commercial flame retardants are reported in Table 1 (below), wherein "nd" means "not determined".

**TABLE 1**

| FLAME RETARDANT TRADE DESIGNATION | TYPE | SUPPLIER | DECOMPOSITION TEMPERATURE, °C | MIXING WITH GEL TEST | CONDUCTIVITY / HUMIDITY AGING |
|---|---|---|---|---|---|
| APYRAL AOH 180E | boehmite | Nabaltec AG, Schwandorf, Germany | 357 | pass | pass |
| BIZON | nitrogen phosphorous based | Firestop Chemicals Ltd., Cheshire, United Kingdom | 164 | nd | nd |
| BUDIT 326 | boron phosphate | Budenheim Iberica Comercial, S.A, Zaragoza, Spain | 100 | nd | nd |
| CHEMGUARD 6 | phosphonate | Chembridge International Corp., Taipei, Taiwan | nd | fail | nd |
| CHEMGUARD 50 | phosphate | Chembridge International Corp. | nd | fail | nd |
| CLOSITE 30B | nanoclay | Southern Clay Products, Inc., Gonzales, Texas | 219 | nd | nd |
| DE83R | brominated flame retardant | Chemtura Corp., Middlebury, Vermont | 351 | nd | nd |
| FF680 | brominated flame retardant | Chemtura Corp. | 288 | nd | nd |
| FR370 | brominated flame retardant | ICL Industrial Products, Beer Sheva, Israel | 312 | nd | nd |
| FRCROS 489 | ammonium polyphosphate | Budenheim Iberica Comercial | 297 | fail | nd |
| HIRETAR - 205 | aromatic phosphinate, 3-(hydroxylphenyl-phosphinyl)-propanoic acid | Kolon Chemical Co., Kwachon, Korea | 220 | nd | nd |
| EXOLIT IFR 23 | ammonium polyphosphate based | Clariant AG, Basel-Land, Switzerland | 206 | nd | nd |
| METALAST INTUMESC-2 | phosphorous based | Metalast International, Inc., Minden, Nevada | 227 | nd | nd |
| KP324 | aromatic phosphinate | Kolon Chemical Co. | 316 | fail | nd |
| EXOLIT OP930 | aliphatic metal phosphinate | Clariant AG | 420 | pass | pass |
| PE-68 | halogenated flame retardant | Chemtura Corp. | 302 | nd | nd |
| REOGARD 2000 | nitrogen phosphorous based | Chemtura Corp. | 292 | fail | fail |
| SAYTEX 8010 | brominated flame retardant | Albemarle Corp., Richmond, Virginia | 376 | nd | nd |
| TRICRESYL PHOSPHATE | aromatic phosphate | RitChem-Co., Inc., Pleasantville, New York | 232 | nd | nd |
| VERTEX 90SF | Magnesium hydroxide (MDH) | JM Huber Corp., Edison, New Jersey | 330 | pass | pass |

### Example 1

Base Composition A (90 parts) was heated at 200 °C for 30 minutes until it melted, and then it was combined with 10 parts of EXOLIT OP930 flame retardant in a bottle and well mixed. After cooling, gel was peeled off from the bottle. The resultant gel (Gel A) was cleanly removed with no residue left in the bottle, and the gel appeared homogeneous with no sign of flame retardant settling.

### Example 2

Base Composition A (95 parts) was heated at 200 °C for 30 minutes until it melted, and then it was combined with 5 parts of EXOLIT OP930 flame retardant in a bottle and well mixed. After cooling, gel was peeled off from the bottle. The resultant gel (Gel B) was cleanly removed with no residue left in the bottle, and the gel appeared homogeneous with no sign of flame retardant settling.

Base Composition A, Gel A, and Gel B, were evaluated according to the Conductivity / Humidity Aging Test, and are were all found to be below 10⁻¹⁴ Siemens/centimeter (S/cm) even after aging at 93 percent relative humidity and 23 °C for 1 month. Results are reported in Table 2 (below).

**TABLE 2**

| | DC CONDUCTIVITY, S/cm | | |
|---|---|---|---|
| | Before Aging | 1 week Aging | 1 month aging |
| Base Composition A | 2.20 x 10⁻¹⁶ | 3.84 x 10⁻¹⁶ | 4.61 x 10⁻¹⁶ |
| Gel A | 1.32 x 10⁻¹⁶ | 1.18 x 10⁻¹⁶ | 1.25 x 10⁻¹⁶ |
| Gel B | 6.51 x 10⁻¹⁶ | 6.35 x 10⁻¹⁶ | 7.75 x 10⁻¹⁶ |

Flammability of Base Composition A and Gel A was evaluated by ASTM E1354-08, Standard Test Method for Heat and Visible Smoke Release Rates for Materials and Products Using an Oxygen Consumption Calorimeter", 2008, (cone calorimeter) and UL746C, "Polymeric Materials - Use in Electrical Equipment Evaluations", February 2006, 20 mm flame tests. Table 3 reports results of the ASTM E1354-08 test (cone calorimeter). In Table 3, the Fire Growth Rate is not included in ASTM E1354-08. It was calculated as the peak heat release rate divided by the time to peak heat release.

**TABLE 3**

| | ASTM E1354 (cone calorimeter) FLAMMABILITY TEST | |
|---|---|---|
| | PEAK HEAT RELEASE RATE, kilowatts/meter² | FIRE GROWTH RATE |
| Base Composition A | 3724 | 26.6 |
| Gel A | 2800 (25% reduction) | 20 (25% reduction) |

Base Composition A, Gel A, and Gel B were used in a 3M 4500 Modular Terminating System electrical connector available from 3M Company, filled with the gel according to normal usage conditions.

Ten replicates of each gel/connector combination were tested according to the UL746C, 20 mm flame test. Base Composition A had a zero percent pass rate, while Gel B had a 20 percent pass rate, and Gel A had a 100 percent pass rate. Eighty percent of the connectors containing Base Composition A exhibited dripping, 50 percent of the connectors containing Gel B exhibited dripping, and none of the connectors containing Gel A exhibited dripping.

## Claims

1. A composition comprising in relative proportion:
60 to 94 parts by weight of mineral oil;
1 to 30 parts by weight of at least one thermoplastic elastomer; and
5 to 30 parts by weight of aluminum diethylphosphinate, and wherein the composition is a gel.

2. The composition of claim 1, wherein the at least one thermoplastic elastomer comprises a styrenic block copolymer.

3. The composition of claim 1, wherein the at least one thermoplastic elastomer is selected from the group consisting of styrene-ethylene/butylene-styrene block copolymers, styrene-ethylene/propylene-styrene block copolymers, and combinations thereof.

4. The composition of claim 1, wherein the at least one thermoplastic elastomer comprises at least one of a diblock copolymer or a triblock copolymer.

5. The composition of claim 1, wherein the at least one thermoplastic elastomer comprises at least one diblock copolymer and at least one triblock copolymer in a respective weight ratio of from 0.25 to 4.

6. The composition of claim 1, wherein the composition comprises 80 to 90 parts by weight of the mineral oil.

7. The composition of claim 1, wherein the composition comprises 4 to 8 parts by weight of the at least one thermoplastic elastomer.

8. The composition of claim 1, wherein the composition comprises 10 to 15 percent of the non-halogenated metal phosphinate.

9. Use of the composition of claim 1 as a gel encapsulant for at least one of an electrical connection or an electrical circuit.

10. Use of the composition of claim 1 as a gel encapsulant in a telecommunications electrical connection block.

11. A method of making a composition, the method comprising combining components comprising: 60 to 94 parts by weight of mineral oil, 1 to 30 parts by weight of thermoplastic elastomer, and 5 to 30 parts by weight of aluminum diethylphosphinate to provide a gel.

12. The method of making a composition of claim 11, wherein the at least one thermoplastic elastomer is selected from the group consisting of styrene-ethylene/butylene-styrene block copolymers, styrene-ethylene/propylene-styrene block copolymers, and combinations thereof.

## Patentansprüche

1. Zusammensetzung, umfassend in relativem Anteil:
60 bis 94 Gewichtsteile Mineralöl;
1 bis 30 Gewichtsteile mindestens ein thermoplastisches Elastomer; und
5 bis 30 Gewichtsteile Aluminiumdiethylphosphinat, und wobei die Zusammensetzung ein Gel ist.

2. Zusammensetzung nach Anspruch 1, wobei das mindestens eine thermoplastische Elastomer ein styrolisches Blockcopolymer umfasst.

3. Zusammensetzung nach Anspruch 1, wobei das mindestens eine thermoplastische Elastomer ausgewählt ist aus der Gruppe bestehend aus Styrol-Ethylen/Butylen-Styrol-Blockcopolymeren, Styrol-Ethylen/Propylen-Styrol-Blockcopolymeren und Kombinationen davon.

4. Zusammensetzung nach Anspruch 1, wobei das mindestens eine thermoplastische Elastomer mindestens eines von einem Diblockcopolymer oder einem Triblockcopolymer umfasst.

5. Zusammensetzung nach Anspruch 1, wobei das mindestens eine thermoplastische Elastomer mindestens ein Diblockcopolymer und mindestens ein Triblockcopolymer in einem jeweiligen Gewichtsverhältnis von 0,25 bis 4 umfasst.

6. Zusammensetzung nach Anspruch 1, wobei die Zusammensetzung zu 80 bis 90 Gewichtsteilen das Mineralöl umfasst.

7. Zusammensetzung nach Anspruch 1, wobei die Zusammensetzung zu 4 bis 8 Gewichtsteilen das mindestens eine thermoplastische Elastomer umfasst.

8. Zusammensetzung nach Anspruch 1, wobei die Zusammensetzung zu 10 bis 15 Prozent das nichthalogenierte Metallphosphinat umfasst.

9. Verwendung der Zusammensetzung nach Anspruch 1 als Gel-Einkapselungsmaterial für mindestens eines von einer elektrischen Verbindung oder einem elektrischen Schaltkreis.

10. Verwendung der Zusammensetzung nach Anspruch 1 als Gel-Einkapselungsmaterial in einem elektrischen Verbindungsblock in der Telekommunikation.

11. Verfahren zum Herstellen einer Zusammensetzung, wobei das Verfahren das Kombinieren von Bestandteilen umfasst, die Folgendes umfassen: 60 bis 94 Gewichtsteile Mineralöl, 1 bis 30 Gewichtsteile thermoplastisches Elastomer und 5 bis 30 Gewichtsteile Aluminiumdiethylphosphinat, um ein Gel bereitzustellen.

12. Verfahren zum Herstellen einer Zusammensetzung nach Anspruch 11, wobei das mindestens eine thermoplastische Elastomer ausgewählt ist aus der Gruppe bestehend aus Styrol-Ethylen/Butylen-Styrol-Blockcopolymeren, Styrol-Ethylen/Propylen-Styrol-Blockcopolymeren und Kombinationen davon.

## Revendications

1. Composition comprenant en proportion relative :
60 à 94 parties en poids d'huile minérale ;
1 à 30 parties en poids d'au moins un élastomère thermoplastique ; et
5 à 30 parties en poids de diéthylphosphinate d'aluminium, et où la composition est un gel.

2. Composition selon la revendication 1, dans laquelle l'au moins un élastomère thermoplastique comprend un copolymère séquencé styrénique.

3. Composition selon la revendication 1, dans laquelle l'au moins un élastomère thermoplastique est choisi dans le groupe constitué de copolymères séquencés styrène-éthylène/butylène-styrène, copolymères séquencés styrène-éthylène/propylène-styrène, et leurs combinaisons.

4. Composition selon la revendication 1, dans laquelle l'au moins un élastomère thermoplastique comprend au moins l'un parmi un copolymère di-séquencé ou un copolymère tri-séquencé.

5. Composition selon la revendication 1, dans laquelle l'au moins un élastomère thermoplastique comprend au moins un copolymère di-séquencé et au moins un copolymère tri-séquencé dans un rapport pondéral respectif allant de 0,25 à 4.

6. Composition selon la revendication 1, où la composition comprend 80 à 90 parties en poids de l'huile minérale.

7. Composition selon la revendication 1, où la composition comprend 4 à 8 parties en poids de l'au moins un élastomère thermoplastique.

8. Composition selon la revendication 1, où la composition comprend 10 à 15 pour cent du phosphinate de métal non halogéné.

9. Utilisation de la composition selon la revendication 1 en tant qu'agent d'encapsulation en gel pour au moins un élément parmi une connexion électrique ou un circuit électrique.

10. Utilisation de la composition selon la revendication 1 en tant qu'agent d'encapsulation en gel dans un bloc de connexion électrique de télécommunications.

11. Procédé de fabrication d'une composition, le procédé comprenant la combinaison de composants comprenant : 60 à 94 parties en poids d'huile minérale, 1 à 30 parties en poids d'élastomère thermoplastique et 5 à 30 parties en poids de diéthylphosphinate d'aluminium pour fournir un gel.

12. Procédé de fabrication d'une composition selon la revendication 11, dans lequel l'au moins un élastomère thermoplastique est choisi dans le groupe constitué de copolymères séquencés styrène-éthylène/butylène-styrène, copolymères séquencés styrène-éthylène/propylène-styrène, et leurs combinaisons.
